Europäisches Patentamt

European Patent Office

Office européen des brevets

(19)

(11) Publication number: **0 209 166**
**B1**

(12) # EUROPEAN PATENT SPECIFICATION

(45) Date of publication of the patent specification:
25.10.89

(51) Int. Cl.⁴: **H01L 29/10**

(21) Application number: 86200921.4

(22) Date of filing: 27.05.86

(54) N channel MOS transistor with limitation of punch-through effect and formation process thereof.

(30) Priority: 19.06.85 IT 2120185

(43) Date of publication of application:
21.01.87 Bulletin 87/4

(45) Publication of the grant of the patent:
25.10.89 Bulletin 89/43

(84) Designated Contracting States:
DE FR GB NL

(56) References cited:
EP-A- 0 083 447
EP-A- 0 088 399

IEEE JOURNAL OF SOLID-STATE CIRCUITS, vol. SC-17,
no. 2, April 1982, pages 237-240, New York, US; H.
SUNAMI et al.: "Characteristics of a buried-channel
graded drain with punchthrough stopper (BGP) MOS
device"
IEEE ELECTRON DEVICE LETTERS, vol. EDL-6, no. 1,
January 1985, pages 36-39, New York, US; D.C. SHAVER
"Microwave operation of submicrometer
channel-length silicon MOSFET's"

(73) Proprietor: SGS-THOMSON MICROELECTRONICS s.r.l.,
Via C. Olivetti, 2, I-20041 Agrate Brianza Milano(IT)

(72) Inventor: Cappelletti, Paolo, Corso Garibaldi, 104,
I-20030 Seveso(IT)
Inventor: Tosi, Marina, Via XI Febbraio 7/F,
I-20056 Trezzo Sull'Adda(IT)

(74) Representative: Mittler, Enrico et al, c/o Marchi & Mittler
s.r.l. Viale Lombardia, 20, I-20131 Milano(IT)

## Description

The present invention relates to an N channel MOS transistor with limitation of punch-through effect and formation process thereof.

By punch-through effect is meant direct conduction between source and drain areas which occurs by interaction of the depleted zones near the source and drain areas when the supply voltage is too great for the transistor.

The current trend is to use very small N channel transistors (1.5 μm) maintaining a relatively high supply voltage (5 volt).

Transistors of this size made with conventional structures and processes (NMOS H2 type) include a doped P-type substrate, two source and drain areas of doped N-type material on the substrate, a P-type substrate surface area interposed between said source and drain areas, and a gate area of doped P-type material superimposed to said substrate surface area. They have punch-through voltages near the supply voltage so that the possibility of punching through is quite high.

The situation cannot be improved by increasing the dope concentration in the substrate because this is known to result in detrimental effects for MOS devices from other viewpoints.

A known compromise solution is to increase the P doping concentration only in the zone between the junctions, between the source and drain areas, leaving unchanged the rest of the substrate. This is achieved in particular with a double implantation of boron with two different energies which gives rise to a high-concentration layer of the desired depth. But this is a basically unsatisfactory solution because if the heavily doped surface layer is too thin it cannot contain the widening of the depleted zones in the sparingly doped part of the substrate, resulting in the possible interaction and passage of punch-through current in depth. If the high-concentration zone is deepened there is a return to the drawbacks which prevent the use of a highly doped substrate.

Also known is increasing the concentration of P dope around the source and drain areas, thus creating D-MOS type structures, since it is between these two areas that interaction takes place. But in this case there is surface formation between the two junction areas of adjacent zones with different P doping which create control and threshold voltage determination problems.

There is disclosed in IEEE ELECTRON DEVICE LETTERS, Vol. Edl 6, No. 1, January 1985, pages 36–39, an N-channel MOS transistor in which the surface area of the substrate between the source and drain areas and deep zones around and under the source and drain areas are implanted with high concentration P doping.

This reduces the punch-through effect to a minimum.

In view of this state of the art the object of the present invention is to accomplish an N channel MOS transistor capable of displaying marked limitation of the punch-through effect without the drawbacks of known solutions.

In accordance with the invention said object has been achieved by means of an N-channel MOS transistor as defined in claim 1.

In this manner the device has on its surface a uniform concentration of P dope in a less deep substrate zone lying between source and drain and in deeper zones surrounding the source and drain areas to contain the extension of the depleted zones.

The high concentration of P dope accomplished in the zone between the source and drain areas prevents the high concentrations of said dope around the aforesaid areas from modifying and making uneven the surface concentration in the channel area. The punch-through effect is thus reduced and the threshold voltage is well defined and easily controlled.

It is important to note that the new features of the device in accordance with the invention lend themselves not only to a conventional transistor but also to an LDD (low doped drain) transistor, which is currently used for many applications. This makes it possible to considerably broaden the area of application of the present invention.

In accordance with the invention there has also been developed a process according to claim 2, for formation of the aforesaid device which will be described in detail below as an example with reference to the annexed drawings wherein:

FIGS. 1-6 show the various stages of a process in accordance with the invention for the formation of a conventional N channel MOS transistor accomplished with the requisites of limitation of the punch-through effect in accordance with the present invention; and

FIGS. 7-8 show variants of the above process for formation of an LDD transistor still having the aforesaid requisites.

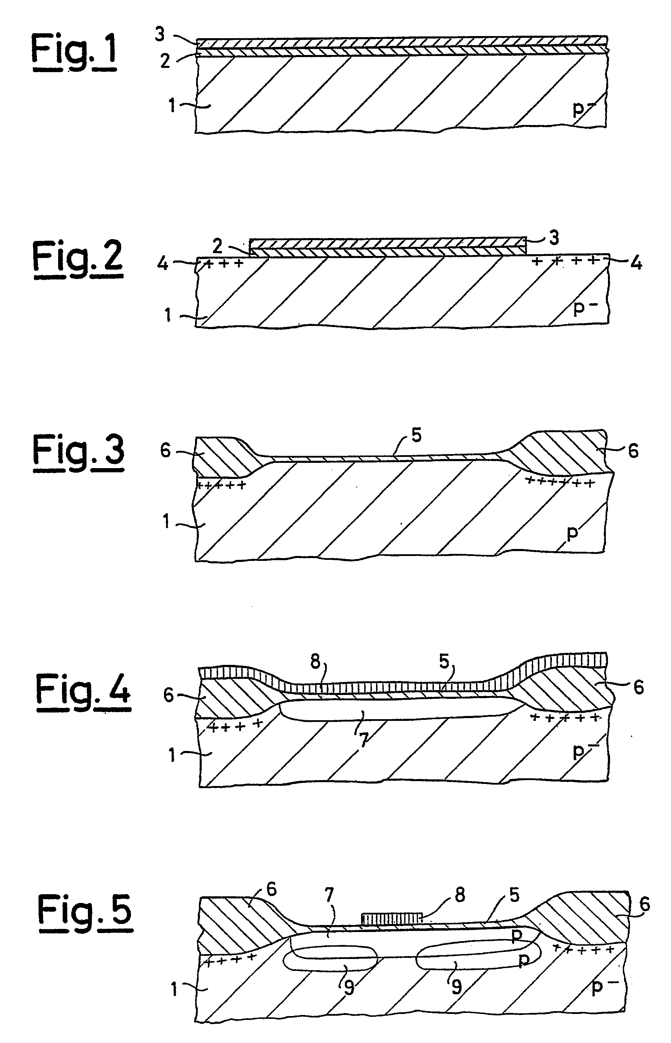

FIG. 1 shows a substrate 1 with low P⁻ doping on which were deposited preliminarily a layer 2 of silicon oxide and a layer 3 of silicon nitride.

By means of etching and with the aid of appropriate photoresistive masking the dual layer of oxide-nitride 2-3 is limited to a restricted area as illustrated in FIG. 2 at the sides of which is implanted insulating boron indicated by the sign +.

Then field oxidation, removal of residual nitride and gate oxidation are performed in succession to obtain the structure shown in FIG. 3 which consists of a low P⁻ doping substrate 1 with insulating implantation 4 and a layer 5 of silicon oxide with enlarged areas 6 which are termed field oxide.

The zone of the substrate 1 between the field oxide areas 6 is then subjected to implantation of channel boron 7 (high concentration P doping) and depositing of a layer of polysilicon 8 (FIG. 4).

By means of etching and with the aid of appropriate photoresistive masking the polysilicon 8 is removed outside a restricted central gate area at the sides of which in alignment with the residual polysilicon and the oxide areas 6 is performed implantation of high energy and concentration boron 9 (P doping) which penetrates deeply in substrate 1 as shown in FIG. 5. Implantation energy is selected in such a manner as to reach a depth greater than that of the previous implantation 7.

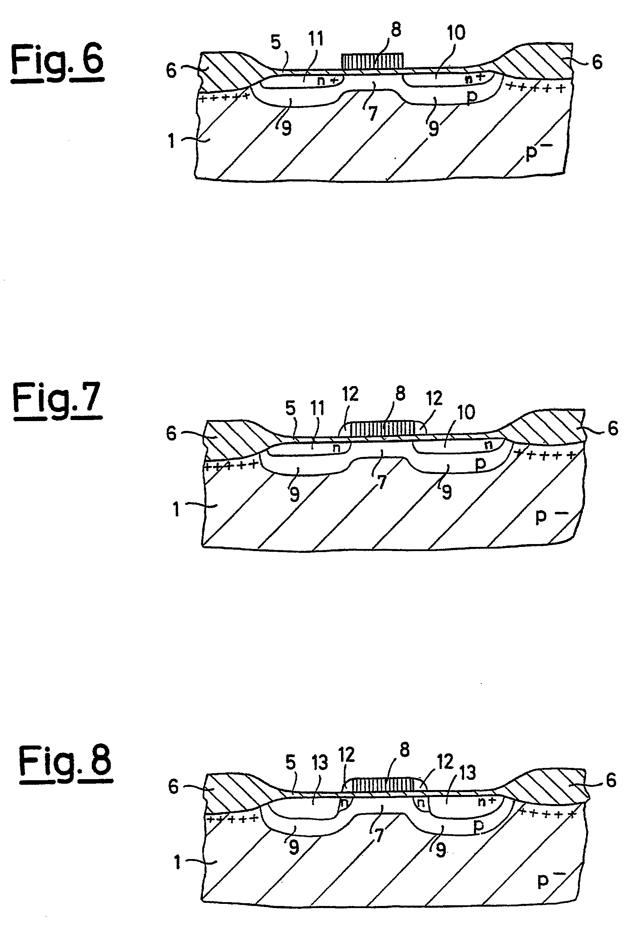

Finally, again between the aforesaid areas, implantation of arsenic is performed to form source and drain areas 10 and 11 which produces the final structure illustrated in FIG. 6.

According to this structure the zone 7 of the substrate between the two source and drain areas 10 and 11 has high P doping and the zones 9 around the areas 10 and 11 are doped in a similar manner. This limits the punch-through effect and at the same time ensures preservation of the normal electrical characteristics and in particular control and setting of the threshold voltage.

The transistor illustrated in FIG. 6 obtained at the end of a process which may be considered conventional up to the stages of FIG. 4 and new in the succeeding stages is an N channel MOS transistor of basically conventional type apart from the limitation of the punch-through effect introduced in accordance with the present invention.

It is possible however to foresee application of the principles of the invention to an LDD (low doped drain) transistor which in this case after the stage shown in FIG. 6 has silicon oxide side spacers 12 (FIG. 7) at the sides of which is performed another high-concentration arsenic implantation 13 ($N^+$). In this manner the final structure illustrated in FIG. 8 is obtained.

It should be noted that while the process described with reference to the drawings is basically an N-MOS process nothing prevents the main steps of said process as illustrated in FIGS. 5-6 being fully applicable with comparable results to the accomplishment of an N channel transistor in a CMOS technology.

## Claims

1. An N-channel MOS transistor comprising a relatively lightly doped P-type substrate (1), two source and drain areas (10, 11) of doped N-type material on said substrate (1) separated from each other by a substrate surface area (7) of relatively heavily doped P-type material, a gate area (8) of doped P-type material superimposed to said substrate surface area (7) and a pair of relatively heavily doped P-type deep zones (9) surrounding said source and drain areas (10, 11), said surface area (7) and said deep zones (9) being provided with the same doping concentration so as to define a uniformly doped substrate surface between, around and under said source and drain areas (10, 11), characterized in that the depth of said surface area (7) is less than that of said deep zones (9).

2. A process for producing a N-channel MOS transistor, comprising the steps of preparing 3 relatively lightly doped P-type substrate (1) with superimposed field oxide regions (6), implanting relatively heavily doped P-type material in a surface part (7) of said substrate (1) and superimposing a gate area (8) of a doped P-type material on a central zone of said surface part (7) of the substrate (1), characterized in that it further comprises the steps of deeply implanting relatively heavily doped P-type material at the sides (9) of said gate area (8) and in alignment therewith up to reach a desired depth beneath said previous implantation of relatively heavily doped P-type material (7) in said substrate (1) and implanting N-type doped material at the sides of said central zone of said substrate surface part (7) and above said deep implantation of doped P-type material (9) to form source and drain areas (10, 11), the doping concentration of said deep implantation of relatively heavily doped P-type material (9) being the same as said previous implantation of relatively heavily doped P-type material (7) so as to define a substrate area (7, 9) with uniform doping concentration between, around and under said source and drain areas (10, 11).

3. A process according to claim 2 for producing an N-channel MOS transistor of LDD type, characterized in that it further comprises the subsequent steps of forming spacers (12) at the sides of the gate area (8) and implanting relatively heavily doped N-type material (13) in the substrate (1) at the sides of said spacers (12) and above said deep implantation of relatively heavily doped P-type material (9).

## Patentansprüche

1. N-Kanal-MOS-Transistor, umfassend ein relativ schwach dotiertes P-leitendes Substrat (1), zwei Source- und Drainbereiche (10, 11) aus dotiertem N-leitendem Material auf dem Substrat (1), die voneinander durch einen Substratoberflächenbereich (7) aus relativ stark dotiertem P-leitendem Material getrennt sind, einen Gatebereich (8) aus dotiertem P-leitendem Material, der dem Substratoberflächenbereich (7) überlagert ist, und ein Paar relativ stark dotierte P-leitende Tiefzonen (9), die die Source-und Drainbereiche (10) umgeben, wobei der Oberflächenbereich (7) und die Tiefzonen (9) die gleiche Dotierstoffkonzentration aufweisen, um zwischen den Source- und Drainbereichen (10, 11), um diese herum und unter diesen eine gleichförmig dotierte Substratoberfläche zu definieren, dadurch gekennzeichnet, daß die Tiefe des Oberflächenbereichs (7) geringer ist als die der Tiefzonen (9).

2. Verfahren zum Herstellen eines N-Kanal-MOS-Transistors, umfassend die Schritte: Vorbereiten eines relativ schwach dotierten P-leitenden Substrats (1) mit darüber liegenden Feldoxidzonen (6), Implantieren von relativ stark dotiertem P-leitendem Material in einem Oberflächenteil (7) des Substrats (1) und Aufbringen eines Gatebereichs (8) aus einem dotierten P-leitendem Material auf eine Mittelzone des Oberflächenteils (7) des Substrats (1), dadurch gekennzeichnet, daß weiterhin die Schritte vorgesehen sind: tiefes Implantieren von relativ stark dotiertem, P-leitendem Material an den Seiten (9) des Gatebereichs (8) in Ausrichtung mit diesem bis zur Erreichung einer gewünschten Tiefe unterhalb der vorausgehenden Implantierung von relativ stark dotiertem, P-leitendem Material (7) in dem Substrat (1), und Implantieren von N-dotiertem Material an den Seiten der mittleren Zone des Substratoberflächenteils (7) und oberhalb der Tiefenimplantation des dotierten P-leitenden Materials (9), um Source- und Drainbereiche (10, 11) zu bilden, wobei die Dotierstoffkonzentration bei der Tiefenimplantation des relativ stark dotierten P-leitenden Materials (9) die gleiche ist wie bei der vorhergehenden Implantation des relativ stark dotierten P-leitenden Materials (7), um einen Substratbereich (7, 9) mit gleichförmiger Dotierstoffkonzentration zwischen den Source- und Drainbereich (10, 11), um diese herum und unter diesen zu definieren.

3. Verfahren nach Anspruch 2 zur Herstellung eines N-Kanal-MOS-Transistors vom LDD-Typ, dadurch gekennzeichnet, daß es weiterhin die anschließenden Schritte aufweist: Bilden von Abstandsstücken (12) an den Seiten des Gatebereichs (8) und Implantieren von relativ stark dotiertem, N-leitenden Material (13) in das Substrat (1) an den Seiten der Abstandsstücke (12) und oberhalb der Tiefenimplantation des relativ stark dotierten P-leitenden Materials (9).

## Revendications

1. Transistor MOS à canal N comprenant un substrat (1) relativement faiblement dopé au type P, deux régions (10, 11) de source et de drain en matière dopée au type N sur ledit substrat (1), séparées l'une de l'autre par une région de surface (7) du substrat en matière relativement fortement dopée au type P, une région de grille (8) en matière dopée au type P, superposée à ladite région (7) de surface du substrat et deux zones profondes (9) relativement fortement dopées au type P, entourant lesdites régions (10, 11) de source et de drain, ladite région (7) de surface et lesdites zones profondes (9) présentant la même concentration de dopage afin de définir une surface de substrat uniformément dopée entre, autour et au-dessous desdites régions (10, 11) de source et de drain, caractérisé en ce que la profondeur de ladite région de surface (7) est inférieure à celle desdites zones profondes (9).

2. Procédé pour la production d'un transistor MOS à canal N, comprenant les étapes qui consistent à préparer un substrat (1) relativement faiblement dopé au type P avec des régions superposées (6) d'oxyde de champ, à implanter une matière relativement fortement dopée au type P dans une partie (7) de surface dudit substrat (1) et à superposer une région de grille (8) en matière dopée au type P sur une zone centrale de ladite partie de surface (7) du substrat (1), caractérisé en ce qu'il comprend en outre les étapes qui consistent à implanter profondément une matière relativement fortement dopée au type P sur les côtés (9) de ladite région de grille (8) et en alignement avec elle jusqu'à atteindre la profondeur souhaitée au-dessous de ladite implantation précédente de matière (7) relativement fortement dopée au type P dans ledit substrat (1) et à implanter une matière dopée au type N sur les côtés de ladite zone centrale de ladite partie de surface (7) du substrat et au-dessus de ladite implanta tion profonde de la matière (9) dopée au type P pour former des régions (10, 11) de source et de drain, la concentration de dopage de ladite implantation profonde de la matière (9) relativement fortement dopée au type P étant la même que ladite implantation précédente de matière (7) relativement fortement dopée au type P afin de définir une région (7, 9) de substrat à concentration uniforme de dopage entre, autour et au-dessous desdites régions (10, 11) de source et de drain.

3. Procédé selon la revendication 2 pour la production d'un transistor MOS à canal N du type LDD, caractérisé en ce qu'il comprend en outre les étapes suivantes qui consistent à former des entretoises (12) sur les côtés de la région de grille (8) et implanter une matière (13) relativement fortement dopée au type N dans le substrat (1) sur les côtés desdites entretoises (12) et au-dessus de ladite implantation profonde de matière (9) relativement fortement dopée au type P.

EP 0 209 166 B1

**Fig.1**

**Fig.2**

**Fig.3**

**Fig.4**

**Fig.5**

Fig. 6

Fig.7

Fig.8